# EUROPEAN PATENT SPECIFICATION

(11) **EP 2 830 099 B1**
(45) Date of publication and mention of the grant of the patent: **05.06.2019**
(21) Application number: 12871702.2
(22) Date of filing: 23.03.2012
(51) Int. Cl.: H01L 31/0224, H01L 31/0236, H01L 31/068

(54) **SOLAR CELL, AND SOLAR CELL MANUFACTURING METHOD**
SOLARZELLE UND HERSTELLUNGSVERFAHREN FÜR EINE SOLARZELLE
CELLULE SOLAIRE ET PROCÉDÉ DE FABRICATION DE CELLULE SOLAIRE

(43) Date of publication of application: 28.01.2015
(73) Proprietor: Panasonic Intellectual Property Management Co., Ltd., Osaka-shi, Osaka 540-6207 (JP)
(72) Inventor: NISHIWAKI, Takeshi, Moriguchi-shi Osaka 570-8677 (JP)
(74) Representative: Glawe, Delfs, Moll
(86) International application number: PCT/JP2012/057481
(87) International publication number: WO 2013/140597

(56) References cited:
- JP-A- 2002 076 398
- JP-A- 2002 076 398
- JP-A- 2004 140 087
- JP-A- 2010 087 131
- JP-A- 2010 109 334
- JP-A- 2011 054 837
- US-A1- 2010 252 095

## Description

### TECHNICAL FIELD

The invention relates to a solar cell, a solar cell module, and a method of manufacturing a solar cell.

### BACKGROUND ART

Patent Document 1 relates to formation of an electrode for a solar cell, and describes the formation of the electrode by applying conductive paste to a surface of a photoelectric conversion body which has a texture structure.

### PRIOR ART DOCUMENT

### PATENT DOCUMENT

Patent Document 1: Japanese Patent Application Publication No. 2002-76398

### SUMMARY OF THE INVENTION

### PROBLEM TO BE SOLVED BY THE INVENTION

There has been a demand for improvement in accuracy of the shape of an electrode for a solar cell.

A main object of the invention is to provide a solar cell including an electrode with high shape accuracy.

### MEANS FOR SOLVING THE PROBLEM

A solar cell of the invention includes a photoelectric conversion body and an electrode. The photoelectric conversion body has a principal surface provided with rugged structures . The electrode is disposed on the principal surface . The electrode includes first conductive materials, second conductive materials and resin. The second conductive materials are flat-shaped so that an aspect ratio of the second conductive materials, which is a ratio of a major axis diameters to their average thickness (the major axis diameter divided by the average thickness), is larger than that of the first conductive materials. In the electrode, a volume fraction of the second conductive materials is larger than that of the first conductive materials. The rugged structures include rugged structures which are larger than an average particle size of the first conductive materials, but smaller than an average major axis diameter of the second conductive materials.

A solar cell module of the invention includes solar cells, a first protection member, a second protection member and a sealing material. The first protection member is disposed on one side of the solar cells. The second protection member is disposed on the opposite side of the solar cells. The sealing material is disposed between the first and second protection members. The sealing material seals the solar cells. Each solar cell includes a photoelectric conversion body and an electrode. The photoelectric conversion body has a principal surface provided with rugged structures. The electrode is disposed on the principal surface. The electrode includes first conductive materials, second conductive materials and resin. The second conductive materials are flat-shaped so that an aspect ratio of the second conductive materials, which is a ratio of a major axis diameter to an average thickness (the major axis diameter divided by the average thickness) , is larger than that of the first conductive materials. In the electrode, a volume fraction of the second conductive materials is larger than that of the first conductive materials. The rugged structures include rugged structures which are larger than the average particle size of the first conductive materials, but smaller than the average major axis diameter of the second conductive materials.

In a method of manufacturing a solar cell of the invention, paste is prepared which includes first conductive materials, second conductive materials and resin. Here, the second conductive materials are flat-shaped so that an aspect ratio of the second conductive materials, which is a ratio of a major axis diameter to an average thickness (the major axis diameter divided by the average thickness) is larger than that of the first conductive materials. In the paste, a volume fraction of the second conductive materials is larger than that of the first conductive materials . The paste is applied to a principal surface of a photoelectric conversion body which is provided with rugged structures larger than the average particle size of the first conductive materials, but smaller than the average major axis diameter of the second conductive materials. Thereby, an electrode including the first conductive materials, the second conductive materials and the resin is formed.

### EFFECTS OF THE INVENTION

The invention can provide a solar cell including an electrode with high shape accuracy.

### BRIEF DESCRIPTION OF THE DRAWINGS

Fig. 1 is a schematic cross-sectional view of a solar cell module of an embodiment of the invention.
Fig. 2 is a schematic plan view of a solar cell of the embodiment of the invention.
Fig. 3 is a schematic rear view of the solar cell of the embodiment of the invention.
Fig. 4 is a schematic cross-sectional view of the solar cell taken along the IV-IV line of Fig. 2.

### MODES FOR CARRYING OUT THE INVENTION

Hereinafter, examples of preferred embodiments carrying out the invention are described. It should be noted that the following embodiments are provided just for illustrative purposes. The invention should not be limited at all to the following embodiments.

In the drawings referred to in the embodiments and other parts, components having substantially the same function are referred to with the same reference numeral. In addition, the drawings referred to in the embodiments and other parts are illustrated schematically, and the dimensional ratio and the like of objects depicted in the drawings are different from those of actual objects in some cases. The dimensional ratio and the like of objects are also different among the drawings in some cases. The specific dimensional ratio and the like of objects should be determined with the following description taken into consideration.

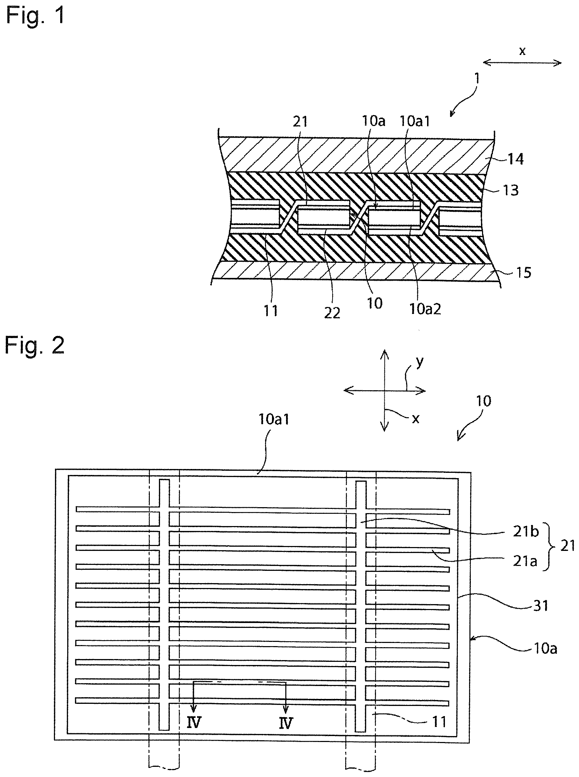

As illustrated in Fig. 1, solar cell module 1 includes a plurality of solar cells 10 electrically connected by wiring materials 11. Otherwise, solar cell module may include one solar cell only.

Solar cell 10 includes photoelectric conversion body 10a. Photoelectric conversion body 10a is configured to generate carriers such as electrons or holes upon receipt of light. Photoelectric conversion body 10a may be configured to generate carriers only when receiving light by use of principal surface 10a1. Otherwise, photoelectric conversion body 10a may be configured to generate power not only when receiving light by use of principal surface 10a1, but also when receiving light by use of principal surface 10a2. Photoelectric conversion body 10a may include, for example, a substrate made of a semiconductor material. To put it concretely, photoelectric conversion body 10a may include, for example, a crystalline silicon plate, and p- and n-type semiconductor layers which are disposed on the crystalline silicone plate. Otherwise, photoelectric conversion body 10a may be made of a crystalline silicon plate which includes p- and n-type dopant diffused regions exposed to the surface.

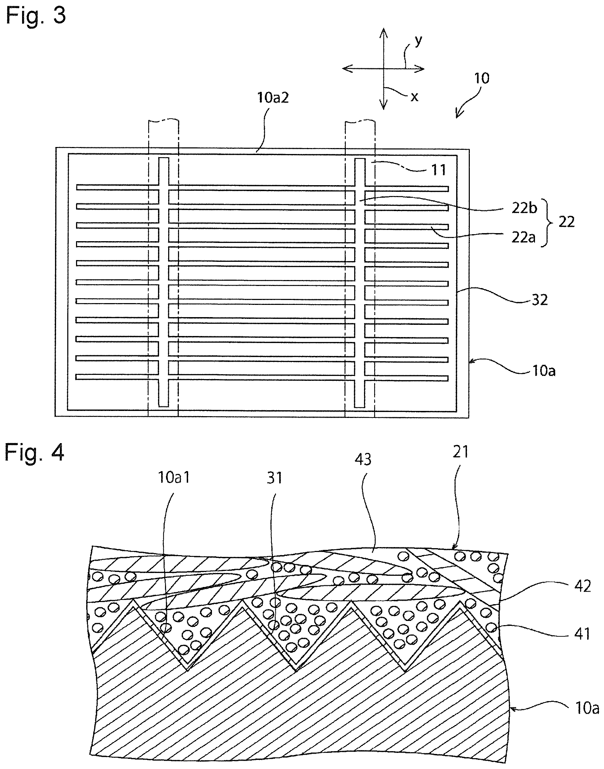

As illustrated in Fig. 4, rugged structures, which are termed as texture structures, are provided to at least one of principal surfaces 10a1, 10a2 of photoelectric conversion body 10a. To put it concretely, the rugged structures termed as texture structures are provided to both principal surfaces 10a1, 10a2. In this respect, the "texture structure" is a rugged structure which is formed to inhibit surface reflection, and to increase the amount of light absorbed by the photoelectric conversion body. A concrete example of the texture structure is a pyramid-shaped (quadrangular pyramid-shaped, truncated quadrangular pyramid-shaped) rugged structure which is obtained by anisotropically etching a surface of a single-crystalline silicon substrate having the (100) plane.

The size of each texture structure (distance between adjacent top portions) is preferably in a range of about 1µm to 20µm, for example, or more preferably in a range of 3µm to 10µm. Nevertheless, the sizes of a plurality of protrusions forming the texture structure are not necessarily the same. A plurality of protrusions forming the texture structure may include protrusions whose sizes fall outside the preferable range.

First and second electrode 21, 22 are disposed on photoelectric conversion body 10a. Specifically, first electrode 21 is disposed on principal surface 10a1, and second electrode 22 is disposed on principal surface 10a2. One of first and second electrodes 21, 22 is an electrode configured to collect majority carriers, and the other electrode is an electrode configured to collect minority carriers.

First electrode 21 includes a plurality of finger portions 21a and bus bar portions 21b. The plurality of finger portions 21a are disposed at intervals in an X-axis direction. The plurality of finger portions 21a are electrically connected to bus bar portions 21b. First electrode 21 is electrically connected to wiring material 11 mainly through bus bar portion 21b.

Second electrode 22 includes a plurality of finger portions 22a and bus bar portions 22b. The plurality of finger portions 22a are disposed at intervals in the X-axis direction. The plurality of finger portions 22a are electrically connected to bus bar portions 22b. Second electrode 22 is electrically connected to wiring material 11 mainly through bus bar portion 22b.

Transparent conductive oxide layer 31 is disposed between first electrode 21 and principal surface 10a1. Transparent conductive oxide layer 31 is disposed covering virtually all principal surface 10a1. Transparent conductive oxide layer 32 is disposed between second electrode 22 and principal surface 10a2. Transparent conductive oxide layer 32 is disposed covering virtually all principal surface 10a2. Transparent conductive oxide layers 31, 32 each may be made of indium tin oxide (ITO), for example.

As illustrated in 4, first electrode 21 include first conductive materials 41, second conductive materials 42 and resin 43. First conductive material 41 may be made of a plurality of particle aggregates . In a case where the particles constituting first conductive material 41 do not form an aggregate, then first conductive material 41 is formed from one particle. In this case, therefore, the particle size of first conductive material 41 is a primary particle size. In a case where particles constituting first conductive material 41 form aggregates, first conductive material 41 is formed from an aggregate containing a plurality of particles. In this case, therefore, the particle size of first conductive material 41 is a secondary particle size. The particle size of the first conductive material can be measured by a laser diffraction/scattering method.

Second conductive materials 42 are flat-shaped. An aspect ratio of second conductive materials 42, which is a ratio of a major axis diameter to an average thickness (the major axis diameter divided by the average thickness) , is larger than that of first conductive materials 41. The aspect ratio of second conductive materials 42 is preferably three or more times as large, or more preferably five or more times as large as the aspect ratio of first conductive materials 41. To put it concretely, the aspect ratio of first conductive materials 41 is preferably in a range of 1 to 3, or more preferably in a range of 1 to 2.

A volume fraction of second conductive materials 42 is larger than that of first conductive materials 41. The volume fraction of second conductive materials 42 is preferably 1.2 or more times, or more preferably 1. 3 or more times that of first conductive materials 41. To put it concretely, the volume fraction of first conductive materials 41 in each of first and second electrodes 21, 22 is preferably in a range of 25 volume percent to 45 volume percent, or more preferably in a range of 30 volume percent to 40 volume percent. The volume fraction of second conductive materials 42 in each of first and second electrodes 21, 22 is preferably in a range of 55 volume percent to 75 volume percent, or more preferably in a range of 60 volume percent to 70 volume percent.

The average particle size of first conductive materials 41 is preferably in a range of 0.5 µm to 3 µm, or more preferably in a range of 0.5 µm to 2 µm. The average major axis diameter of second conductive materials 42 is preferably in a range of 3 µm to 10 µm, or more preferably in a range of 5 µm to 8 µm. The average thickness of second conductive materials 42 is preferably in a range of 0.1 µm to 1.5 µm, or more preferably in a range of 0.3 µm to 1 µm. The average major axis diameter and average thickness of second conductive materials 42 can be measured by SEM observation.

First and second conductive materials 41, 42 each may be made of an appropriate conductive material. First and second conductive materials 41, 42 each may be made of at least one metal selected from a group consisting of Ag, Cu, Au, Pt, Al, Ni and Sn, for example. It is desirable that the essential component of first conductive materials 41 and the essential component of second conductive materials 42 be the same. For example, it is desirable that first and second conductive materials 41, 42 both contain Ag or Au as an essential component.

As illustrated in Fig. 1, first protection member 14 is disposed on one side of solar cells 10. Second protection member 15 is disposed on the opposite side of solar cells 10. Sealing material 13 is disposed between first and second protection members 14, 15. Sealing material 13 seals solar cells 10. At least one of first and second protection members 14, 15 includes a resin sheet. To put it concretely, at least one of first and second protection members 14, 15 includes a resin sheet which does not include a barrier layer such as a metal layer or an inorganic oxide layer. To put it more concretely, first protection member 14 placed on a light receiving surface side of solar cells 10 is made of a glass plate, a ceramic plate or a resin plate. Second protection member 15 placed on the rear surface side of solar cells 10 includes a resin sheet which does not include a barrier layer such as a metal layer or an inorganic oxide layer. Sealing material 13 may be made of a crosslinked resin such as ethylene-vinyl acetate copolymer, or a non-crosslinked resin such as polyolefin.

First and second electrodes 21, 22 can be formed in the following procedure, for example. Specifically, Prepared is conductive paste including first and second conductive materials 41, 42 and resin 43. In this conductive paste, the volume fraction of second conductive materials 42 is larger than that of first conductive materials 41. Thereafter, the conductive paste is applied onto photoelectric conversion body 10a, and resin 43 is cured. Thereby, first and second electrodes 21, 22 can be formed.

For example, if the particle sizes of the conductive materials included in the conductive paste are smaller than pitches of the rugged structures, the conductive materials, together with the resin in the applied conductive paste, are easily spread along recessed portions in the rugged structures . For this reason, it is difficult to apply the conductive paste with high shape accuracy. This makes it difficult to form the electrodes with high shape accuracy.

Here, second conductive materials 42 are flat-shaped. The rugged structures include rugged structures smaller (narrower in pitch) than the major axis diameters of second conductive materials 42. For this reason, second conductive materials 42 are hard to spread along the recessed portions in the rugged structures. Second conductive materials 42 that are hard to spread are included in the conductive paste by the higher volume fraction than that of the first conductive materials. This makes it possible to obtain electrodes 21, 22 with high shape accuracy.

An increase in viscosity of the conductive paste, for example, makes it possible to inhibit wetting spread of the conductive paste, too. However, it is difficult to apply the conductive paste if the viscosity of the conductive paste is high. As a consequence, the shape accuracy of the obtained electrodes may be degraded if the viscosity of the conductive paste is high. In the case where second conductive materials 42 are flat-shaped while the rugged structures include rugged structures smaller (narrower in pitch) than the major axis diameters of second conductive materials 42, the conductive paste is hard to wettingly spread even though the viscosity of the conductive paste is lower. This makes it possible to obtain electrodes 21, 22 with high shape accuracy.

For example, if the electrodes include only the second conductive materials with the higher aspect ratio, the second conductive materials have difficulty in getting into the rugged structures. As a result, the electric resistance is likely to become higher in the interfaces between the electrodes and the photoelectric conversion body, or in the interfaces between the electrodes and the transparent conductive oxide layers. In solar cell module 1, electrodes 21, 22 each include not only second conductive materials 42 but also first conductive materials 41. The rugged structures include the rugged structures larger than the average particle size of first conductive materials 41. For this reason, the electric resistance is low in the interfaces between electrodes 21, 22 and transparent conductive oxide layers 31, 32. Accordingly, the improved photoelectric conversion efficiency can be realized.

From a viewpoint of a further improving the photoelectric conversion efficiency and obtaining electrodes 21, 22 with higher shape accuracy, it is desirable that more than a half, or more preferably, virtually all of the rugged structures provided to at least one of principal surfaces 10a1, 10a2 of photoelectric conversion body 10a be larger than the average particle size of first conductive materials 41, but smaller than the average major axis diameter of second conductive materials 42. It is desirable that the rugged structures include rugged structures which are three or more times the average particle size of first conductive materials 41, but two or less times the average major axis diameter of second conductive materials 42. More desirably, the rugged structures include the rugged structures which are five or more times the average particle size of first conductive materials 41, but 1.5 or less times the average major axis diameter of second conductive materials 42. It is desirable that more than a half, or more preferably, virtually all of the rugged structures be three or more times the average particle size of first conductive materials 41, but two or less times the average major axis diameter of second conductive materials 42. It is more desirable that more than a half or virtually all of the rugged structures be five or more times the average parcel size of first conductive materials 41, but 1.5 or less times the average major axis diameter of second conductive materials 42.

Meanwhile, if at least any one of first and second protection members 14, 15 includes a resin sheet without including a barrier layer, moisture is highly likely to enter sealing material 13 via such the resin sheet. If the moisture entering sealing material 13 reaches electrodes 21, 22, resin 43 in electrodes 21, 22 deteriorates. As a result, it is more likely that: electric resistance becomes higher in the interfaces between electrodes 21, 22 and transparent conductive oxide layers 31, 32; and the photoelectric conversion efficiency deteriorates. In solar cell module 1, electrodes 21, 22 include flat-shaped second conductive materials 42. For this reason, the number of conductive materials 41, 42 existing in each unit length is small in electrodes 21, 22. As a consequence, the number of spaces between the conductive materials existing in each unit length is small, too. Accordingly, even if the electric resistance rises in resin 43 located in the spaces between the conductive materials, the electric resistance such as contact resistance is less likely to rise in electrodes 21, 22. This makes the output characteristics of solar cell module 1 less likely to become worse. In short, since the volume fraction of flat-shaped second conductive materials 42 having the relatively higher aspect ratio is set larger than that of first conductive materials 41, the moisture resistance of solar cell module 1 can be improved.

### (Modified Examples)

Each electrode may be disposed directly on the photoelectric conversion body. In other words, the transparent conductive oxide layer does not have to be disposed between each electrode and the photoelectric conversion body. Each electrode may be provided in a planar shape. The solar cell may be a back contact solar cell.

### EXPLANATION OF REFERENCE NUMERALS

- 1: solar cell module
- 10: solar cell
- 10a: photoelectric conversion body
- 10a1, 10a2: principal surface
- 11: wiring material
- 13: sealing material
- 14: first protection member
- 15: second protection member
- 21: first electrode
- 22: second electrode
- 31, 32: transparent conductive oxide layer
- 41: first conductive material
- 42: second conductive material
- 43: resin

## Claims

1. A solar cell (10) comprising:
a photoelectric conversion body (10a) including a principal surface provided with rugged structures, and
an electrode disposed on the principal surface, and including first conductive materials (41), second conductive materials (42) and resin (43), wherein
the second conductive materials are flat-shaped so that an aspect ratio of the second conductive materials that is a ratio of a major axis diameter to an average thickness (major axis diameter / average thickness) is larger than that of the first conductive materials,
in the electrode, a volume fraction of the second conductive materials is larger than that of the first conductive materials,
**characterised in that**
50% or more of the rugged structures are rugged structures which are larger than an average particle size of the first conductive materials, but smaller than an average major axis diameter of the second conductive materials.

2. The solar cell according to claim 1, wherein in the electrode, the volume fraction of the second conductive materials (42) is 1.2 or more times the volume fraction of the first conductive materials (41).

3. The solar cell according to claim 1 or 2, wherein the rugged structures include rugged structures which are three or more times the average particle size of the first conductive materials, but are two or less times the average major axis diameter of the second conductive materials.

4. The solar cell module according to any of claims 1, 2 or 3, wherein the major amount of the first conductive particles is accumulated between protrusions of the rugged structures.

5. The solar cell according to any one of claims 1 to 4, wherein
the aspect ratio of the first conductive materials is in a range of 1 to 3, and
the aspect ratio of the second conductive materials is in a range of 5 to 20.

6. The solar cell according to any one of claims 1 to 5, wherein the first conductive materials and the second conductive materials contain the same component as a main component.

7. A solar cell module comprising:
a solar cell according to any of claims 1 to 6;
a first protection member (14) disposed on one side of the solar cell;
a second protection member (15) disposed on an opposite side of the solar cell; and
a sealing material (13) disposed between the first protection member and the second protection member, and sealing the solar cell.

8. The solar cell module according to claim 7, wherein at least one of the first and second protection members includes a resin sheet.

9. A method of manufacturing a solar cell comprising:
preparing paste which includes first conductive materials, second conductive materials and resin, in which the second conductive materials are flat-shaped so that an aspect ratio of the second conductive materials, which is a ratio of a major axis diameter to an average thickness (the major axis diameter divided by the average thickness) is larger than those of the first conductive materials, and in which a volume fraction of the second conductive materials is larger than that of the first conductive materials; and
forming an electrode including the first conductive materials, the second conductive materials and the resin by applying the paste onto a principal surface of a photoelectric conversion body, the principal surface provided with rugged structures
**characterised in that**
50 % or more of the rugged structures are larger than an average particle size of the first conductive materials, but smaller than an average major axis diameter of the second conductive materials.

## Patentansprüche

1. Solarzelle (10) mit:
einem photoelektrischen Wandlerkörper (10a) mit einer Hauptfläche, die mit rauen Strukturen versehen ist, und
einer Elektrode, die auf der Hauptfläche angeordnet ist und erste leitfähige Materialien (41), zweite leitfähige Materialien (42) und ein Harz aufweist, wobei
die zweiten leitfähigen Materialien flach geformt sind, sodass ein Seitenverhältnis der zweiten leitfähigen Materialien, das ein Verhältnis eines Hauptachsendurchmessers zu einer mittleren Dicke ist (Hauptachsendurchmesser/mittlere Dicke), größer als das der ersten leitfähigen Materialien ist,
wobei in der Elektrode ein Volumenanteil der zweiten leitfähigen Materialien größer als der der ersten leitfähigen Materialien ist, **dadurch gekennzeichnet**,
das 50 % oder mehr der rauen Strukturen raue Strukturen sind, die größer als eine mittlere Partikelgröße der ersten leitfähigen Materialien sind, aber kleiner als der mittlere Hauptachsendurchmesser der zweiten leitfähigen Materialien sind.

2. Solarzelle nach Anspruch 1, wobei in der Elektrode der Volumenanteil der zweiten leitfähigen Materialien (42) das 1,2- oder mehrfache des Volumenanteils der ersten leitfähigen Materialien (41) beträgt.

3. Solarzelle nach Anspruch 1 oder 2, wobei die rauen Strukturen raue Strukturen aufweisen, die das drei- oder mehrfache der mittleren Partikelgröße der ersten leitfähigen Materialien aufweisen aber das zweifache oder weniger des mittleren Hauptachsendurchmessers der zweiten leitfähigen Materialien.

4. Solarzellenmodul nach einem der Ansprüche 1, 2 oder 3, wobei der Hauptanteil der ersten leitfähigen Partikel zwischen Vorsprüngen der rauen Strukturen angesammelt ist.

5. Solarzelle nach einem der Ansprüche 1 bis 4, wobei
das Seitenverhältnis der ersten leitfähigen Materialien in einem Bereich von 1 bis 3 ist und
das Seitenverhältnis der zweiten leitfähigen Materialien in einem Bereich von 5 bis 20 liegt.

6. Solarzelle nach einem der Ansprüche 1 bis 5, wobei die ersten leitfähigen Materialien und die zweiten leitfähigen Materialien dieselbe Komponente als Hauptkomponente enthalten.

7. Solarzellenmodul mit:
einer Solarzelle nach einem der Ansprüche 1 bis 6,
einem ersten Schutzelement (14), das an einer Seite der Solarzelle angeordnet ist,
einem zweiten Schutzelement (15), das an einer entgegengesetzten Seite der Solarzelle angeordnet ist, und
einem Dichtungsmaterial (13), das zwischen dem ersten Schutzelement und dem zweiten Schutzelement angeordnet ist und die Solarzelle abdichtet.

8. Solarzellenmodul nach Anspruch 7, wobei mindestens eines des ersten und des zweiten Schutzelements eine Harzfolie umfasst.

9. Verfahren zur Herstellung einer Solarzelle mit:
Herstellung einer Paste, die erste leitfähige Materialien, zweite leitfähige Materialien und ein Harz enthält, wobei die zweiten leitfähigen Materialien flach geformt sind, sodass ein Seitenverhältnis der zweiten leitfähigen Materialien, was ein Verhältnis eines Hauptachsendurchmessers zu einer mittleren Dicke ist (der Hauptachsendurchmesser geteilt durch die mittlere Dicke), größer ist als das der ersten leitfähigen Materialien und wobei ein Volumenanteil der zweiten leitfähigen Materialien größer als der der ersten leitfähigen Materialien ist, und
Ausbildung einer Elektrode mit den ersten leitfähigen Materialien, den zweiten leitfähigen Materialien und dem Harz durch Anwendung der Paste auf einer Hauptfläche eines photoelektrischen Wandlerkörpers, wobei die Hauptfläche mit rauen Strukturen versehen ist, **dadurch gekennzeichnet,**
**dass** 50 % oder mehr der rauen Strukturen größer als eine mittlere Partikelgröße der ersten leitfähigen Materialien sind, aber kleiner als ein mittlerer Hauptachsendurchmesser der zweiten leitfähigen Materialien.

## Revendications

1. Cellule solaire (10) comprenant :
un corps de conversion photoélectrique (10a) comprenant une surface principale pourvue de structures en relief et
une électrode disposée sur la surface principale et comprenant des premiers matériaux conducteurs (41), des seconds matériaux conducteurs (42) et de la résine (43), dans laquelle
les seconds matériaux conducteurs ont une forme plate de sorte qu'un facteur de forme des seconds matériaux conducteurs qui est un rapport d'un diamètre de grand axe sur une épaisseur moyenne (diamètre de grand axe/épaisseur moyenne) est plus grand que celui des premiers matériaux conducteurs,
dans l'électrode, une fraction volumique des seconds matériaux conducteurs est plus grande que celle des premiers matériaux conducteurs,
**caractérisée en ce que**
50 % ou plus de 50 % des structures en relief sont des structures en relief qui sont plus grandes qu'une taille moyenne des particules des premiers matériaux conducteurs, mais plus petites qu'un diamètre moyen de grand axe des seconds matériaux conducteurs.

2. Cellule solaire selon la revendication 1, dans laquelle dans l'électrode, la fraction volumique des seconds matériaux conducteurs (42) est de 1,2 ou plus de 1,2 fois la fraction volumique des premiers matériaux conducteurs (41).

3. Cellule solaire selon la revendication 1 ou 2, dans laquelle les structures en relief comprennent des structures en relief qui ont trois ou plus de trois fois la taille moyenne des particules des premiers matériaux conducteurs, mais qui ont deux ou moins de deux fois le diamètre moyen de grand axe des seconds matériaux conducteurs.

4. Module de cellule solaire selon l'une quelconque des revendications 1, 2 ou 3, dans lequel la majeure partie des premières particules conductrices s'est accumulée entre des parties en saillie des structures en relief.

5. Cellule solaire selon l'une quelconque des revendications 1 à 4, dans laquelle
le facteur de forme des premiers matériaux conducteurs est dans une plage de 1 à 3 et
le facteur de forme des seconds matériaux conducteurs est dans une plage de 5 à 20.

6. Cellule solaire selon l'une quelconque des revendications 1 à 5, dans laquelle les premiers matériaux conducteurs et les seconds matériaux conducteurs contiennent le même constituant en tant que constituant principal.

7. Module de cellule solaire comprenant :
une cellule solaire selon l'une quelconque des revendications 1 à 6 ;
un premier élément de protection (14) disposé sur un côté de la cellule solaire ;
un second élément de protection (15) disposé sur un côté opposé de la cellule solaire ; et
un matériau d'étanchéité (13) disposé entre le premier élément de protection et le second élément de protection et isolant hermétiquement la cellule solaire.

8. Module de cellule solaire selon la revendication 7, dans lequel au moins l'un des premier et second éléments de protection comprend une feuille de résine.

9. Procédé de fabrication d'une cellule solaire comprenant :
la préparation de pâte qui comprend des premiers matériaux conducteurs, des seconds matériaux conducteurs et de la résine, les seconds matériaux conducteurs ayant une forme plate de sorte qu'un facteur de forme des seconds matériaux conducteurs, qui est un rapport d'un diamètre de grand axe sur une épaisseur moyenne (le diamètre de grand axe divisé par l'épaisseur moyenne), est plus grand que celui des premiers matériaux conducteurs et une fraction volumique des seconds matériaux conducteurs étant plus grande que celle des premiers matériaux conducteurs ; et
la formation d'une électrode comprenant les premiers matériaux conducteurs, les seconds matériaux conducteurs et la résine par application de la pâte sur une surface principale d'un corps de conversion photoélectrique, la surface principale étant pourvue de structures en relief, **caractérisé en ce que**
50 % ou plus de 50 % des structures en relief sont plus grandes qu'une taille moyenne des particules des premiers matériaux conducteurs, mais plus petites qu'un diamètre moyen de grand axe des seconds matériaux conducteurs.
